# EUROPÄISCHE PATENTSCHRIFT

(11) **EP 2 802 194 B1**
(45) Veröffentlichungstag und Bekanntmachung des Hinweises auf die Patenterteilung: **05.09.2018**
(21) Anmeldenummer: 14167173.5
(22) Anmeldetag: 06.05.2014
(51) Int. Cl.: H05K 5/06, H05K 7/20

(54) **Druckfest gekapseltes Gehäuse mit einer Kühlvorrichtung**
Pressure-tightly encapsulated housing comprising a cooling device
Boîtier encapsulé résistant à la pression doté d'un dispositif de refroidissement

(30) Priorität: 06.05.2013 DE 102013104627
(43) Veröffentlichungstag der Anmeldung: 12.11.2014
(73) Patentinhaber: R. Stahl Schaltgeräte GmbH, 74638 Waldenburg (DE)
(72) Erfinder: Walch, Otto, 74582 Gerabronn (DE); Poidl, Jürgen, 74653 Kocherstetten (DE)
(74) Vertreter: Rüger, Barthelt & Abel

(56) Entgegenhaltungen:
- WO-A1-2012/003895
- DE-A1- 10 152 510
- JP-A- 2003 028 549
- US-A1- 2004 008 483
- US-A1- 2009 067 129

## Beschreibung

Die Erfindung betrifft ein druckfest gekapseltes Gehäuse mit einer Temperiervorrichtung, die eine im Inneren des Gehäuses angeordnete erste Wärmetauschereinheit und eine außerhalb des Gehäuses angeordnete zweite Wärmetauschereinheit aufweist. Die beiden Wärmetauschereinheiten sind über einen Flüssigkeitskreislauf miteinander verbunden. Auf diese Weise können Komponenten im druckfest gekapselten Gehäuse je nach Bedarf gekühlt und/oder erwärmt werden.

Ein solches Gehäuse ist beispielsweise aus WO 2010/132211 A1 bekannt. Die beiden Wärmetauschereinheiten im bzw. außerhalb des Gehäuses sind über Kühlmittelrohe miteinander verbunden, die durch die Wand des Gehäuses geführt sind.

Die Wanddurchführung der Rohre kann die Zünddurchschlagsicherheit des Gehäuses beeinträchtigen. Das aus DE 101 52 510 A1 bekannte druckfest gekapselte Gehäuse weist einen Kühlmitteldurchgang auf, in dem eine druckfeste Sperre mit einer Vielzahl von Durchlasskanälen für das flüssige Kühlmittel vorhanden ist. Die Sperre wird von dem Kühlmittel durchströmt und stellt die Zünddurchschlagsicherheit innerhalb des Rohres zwischen dem Inneren des druckfest gekapselten Gehäuses und der Umgebung her. Solche Sperren erhöhen den Strömungswiderstand, was wiederum dazu führt, dass die Förderung des Kühlmittels entlang des Kühlmittelskreislaufs eine erhöhte Leistung erfordert.

US 2010/0284150 A1 beschreibt ein explosionsgeschütztes Gehäuse. Zur zünddurchschlagsicheren Luftströmung durch das Innere des Gehäuses sind zwei Flammsperren aus gesintertem Material in Anschlussstutzen an Wanddurchlässe eingesetzt. Im Prinzip entspricht diese Vorgehensweise dem Inhalt der DE 101 52 510 A1, wobei anstelle eines flüssigen Kühlmediums die Kühlung im Gehäuse durch eine Luftzirkulation bewirkt wird. Die Luftkühlung von Komponenten im Gehäuseinneren ist allerdings in vielen Fällen unzureichend.

Aus US 2009/0067129 A1 ist ein Gehäuse bekannt, das eine Temperaturregeleinrichtung mit einer im Inneren des Gehäuses und einer außen am Gehäuse angeordneten Einheit aufweist, wobei die beiden Einheiten durch Rohre miteinander verbunden sind, die explosionsgeschützt durch eine Wand geführt sind. Eine ähnliche Anordnung beschreibt auch JP 2003-028549 A.

WO 2012/003895 A1 offenbart ein Kühlsystem für eine Rechenanlage. Das Kühlsystem kann Mittel zur Erkennung eines Kühlmittelverlusts aufweisen. US 2004/0008483 A1 beschreibt ein Wasserkühlsystem für eine elektronische Einrichtung. Weder WO 2012/003895 A1 noch US 2004/0008483 A1 betreffen das technische Gebiet des Explosionsschutzes.

Ausgehend von dem genannten Stand der Technik kann es als Aufgabe der vorliegenden Erfindung vorgesehen werden, ein explosionsgeschütztes Gehäuse in der Zündschutzart druckfeste Kapselung (Ex-d) zu schaffen, das eine verbesserte Temperiervorrichtung zum Kühlen und/oder Wärmen einer oder mehrerer im Inneren des Gehäuses angeordneter Komponenten aufweist.

Diese Aufgabe wird durch ein druckfest gekapseltes Gehäuse mit den Merkmalen des Patentanspruches 1 sowie ein Verfahren zur Überwachung eines druckfest gekapselten Gehäuses mit den Merkmalen des Patentanspruches 12 gelöst.

Das druckfest gekapselte Gehäuse weist eine Temperiervorrichtung mit zwei Wärmetauschereinheiten auf, die über einen Flüssigkeitskreislauf miteinander verbunden sind. Im Flüssigkeitskreislauf zirkuliert ein flüssiges Wärmeträgermedium. Die erste Wärmetauschereinheit ist im Inneren des Gehäuses angeordnet. Die zweite Wärmetauschereinheit befindet sich außerhalb des Gehäuses. Über die eine Wärmetauschereinheit kann Wärme an die Flüssigkeit abgegeben und über die jeweils andere Wärmetauschereinheit kann Wärme von der Flüssigkeit aufgenommen und die erwärmte Flüssigkeit gekühlt werden. Dadurch ist es möglich, das Innere des Gehäuses bzw. die dort vorhandenen Komponenten zu temperieren, also zu kühlen oder zu erwärmen. In vielen Fällen wird es notwendig sein, die durch die elektrischen Komponenten im Gehäuseinneren abgegebene Wärme mittels der ersten Wärmetauschereinheit aufzunehmen und über die Flüssigkeit im Flüssigkeitskreislauf nach außen zu der zweiten Wärmetauschereinheit zu transportieren und dort an die Umgebung abzugeben.

Der Flüssigkeitskreislauf weist im Gehäuse eine Zulaufleitung und eine Rücklaufleitung auf, die jeweils mit der ersten Wärmetauschereinheit fluidisch verbunden sind. Die beiden Leitungen sind an jeweils eine Durchführungseinheit angeschlossen. Die Zulaufleitung und die Rücklaufleitung sind jeweils mit einem Durchgangskanal der zugeordneten Durchführungseinheit fluidisch verbunden. Die Durchführungseinheit ist über ein zünddurchschlagsicheres Befestigungsmittel in einer der Wände des Gehäuses zünddurchschlagsicher angeordnet, wobei sich der Durchgangskanal im Inneren der Durchführungseinheit durch die Wand erstreckt. Der Durchgangskanal ist vorzugsweise zylindrisch ausgeführt und erstreckt sich durch einen Durchgangskörper der Durchführungseinheit hindurch.

Das druckfest gekapselte Gehäuse weist außerdem wenigstens einen Flüssigkeitsüberwachungssensor auf. Es ist auch möglich, mehrere Flüssigkeitsüberwachungssensoren vorzusehen und beispielsweise jeder Durchgangseinheit einen separaten Flüssigkeitsüberwachungssensor zuzuordnen. Der wenigstens eine Flüssigkeitsüberwachungssensor erzeugt ein Flüssigkeitsüberwachungssignal, das an eine Überwachungseinheit übermittelt wird. Das Flüssigkeitsüberwachungssignal des wenigstens einen Flüssigkeitsüberwachungssensors beschreibt die Füllung der Durchgangskanäle bzw. des jeweils zugeordneten Durchgangskanals mit Flüssigkeit. Das Flüssigkeitsüberwachungssignal ist charakteristisch dafür, ob der Querschnitt des Durchgangskanals bzw. der Durchgangskanäle ausreichend und insbesondere vollständig mit Flüssigkeit des Flüssigkeitskreislaufs gefüllt ist bzw. sind, also ob sich innerhalb eines Durchgangskanals kein Zündspalt gebildet haben kann oder nicht.

Der Flüssigkeitsüberwachungssensor kann beispielsweise als Füllstandssensor ausgeführt sein. Es ist auch möglich, den Füllstand über einen Drucksensor, der den Flüssigkeitsdruck im Flüssigkeitskreislauf misst, indirekt zu bestimmen. Auch über Volumen- oder Massenstromsensoren, Temperatursensoren oder dergleichen kann die Füllung der Durchgangskanäle unmittelbar oder mittelbar ermittelt werden. Es können auch mehrere Flüssigkeitsüberwachungssensoren vorhanden sein, die unterschiedliche charakteristische Größen wie z.B. Füllstand, Druck oder Temperatur erfassen.

Aufgrund der Überwachung der Füllung der Durchgangskanäle der Durchführungseinheiten sind Flammsperren innerhalb des Flüssigkeitskreislaufs nicht notwendig und können entfallen. Auch eine druckfeste Ausgestaltung bzw. Kapselung des Flüssigkeitskreislaufs und der Wärmetauschereinheiten ist nicht notwendig. Somit kann der Flüssigkeitskreislauf ohne strömungshindernde Flammsperren in den Durchführungseinheiten ausgeführt und eine optional vorhandene Flüssigkeitspumpe mit geringerer Pumpenleistung betrieben werden. Die Energieeffizienz ist dadurch erhöht.

Vorteilhafterweise ist die Überwachungseinheit mit einer ansteuerbaren Trenneinrichtung verbunden. Eine elektrische Versorgungsleitung führt in das Innere des druckfest gekapselten Gehäuses, um die dort vorhandenen elektrischen und/oder elektronischen Komponenten mit elektrischer Energie zu versorgen. Die Trenneinrichtung ist in zumindest einen Leiter der Versorgungsleitung eingesetzt und kann die Zufuhr von elektrischer Energie und somit das Bereitstellen von elektrischer Spannung im Inneren des Gehäuses unterbinden, wenn sie sich in ihrem Trennzustand befindet. Die Überwachungseinheit kann die Trenneinrichtung abhängig vom Flüssigkeitsüberwachungssignal in ihren Trennzustand umschalten, so dass unsichere Betriebszustände vermieden und die Explosionsgefahr ausgeschlossen werden kann.

Die Überwachungseinheit ist dazu eingerichtet, das Flüssigkeitsüberwachungssignal auszuwerten. Wird anhand dieser Auswertung ein unzureichender Explosionsschutz festgestellt, erzeugt die Überwachungseinheit ein erstes Ausgangssignal. Ansonsten kann ein zweites Ausgangssignal erzeugt werden. Das erste Ausgangssignal wird hervorgerufen, wenn das wenigstens eine Flüssigkeitsüberwachungssignal angibt, dass zumindest einer der beiden Durchgangskanäle eine unzureichende Füllung mit Flüssigkeit aufweist. Dadurch könnte sich ein Zündspalt bilden. Ein derartiger Betriebszustand wird somit vermieden.

Vorzugsweise wird das erste Ausgangssignal, das einen unzureichenden Explosionsschutz charakterisiert, dazu verwendet, die Trenneinrichtung in ihren Trennzustand umzuschalten und die Spannungs- und Stromversorgung für die Komponenten im Gehäuse zu unterbrechen. Alternativ oder zusätzlich könnte anhand des ersten Ausgangssignals und/oder des zweiten Ausgangssignals auch ein Alarm bzw. ein entsprechendes Anzeigesignal für eine Bedienperson erzeugt werden.

Die Überwachungseinheit kann außerdem mit einem Temperatursensor verbunden sein, der ein für die Oberflächentemperatur an der Außenfläche des Gehäuses charakteristisches Temperatursignal erzeugt. Das Temperatursignal kann in der Überwachungseinheit ausgewertet werden. Insbesondere wird dann, wenn das Temperatursignal einen vorgegebenen Schwellenwert überschreitet, ein den unzureichenden Explosionsschutz charakterisierendes drittes Ausgangssignal durch die Überwachungseinheit hervorgerufen und ein Alarm und/oder das Umschalten der Trenneinrichtung in den Trennzustand ausgelöst. Eine zu hohe Oberflächentemperatur im Gehäuse kann in einer explosionsgefährdeten Umgebung eine Explosion auslösen. Diese Gefahr wird durch die Überwachung der Oberflächentemperatur vermieden.

Vorzugsweise wird das Zirkulieren der Flüssigkeit im Flüssigkeitskreislauf fortgesetzt, wenn eine zu hohe Oberflächentemperatur des Gehäuses festgestellt wurde, um die Temperatur zu senken. Eine optional im Flüssigkeitskreislauf vorhandene Flüssigkeitspumpe bleibt somit im Betrieb.

Der Temperatursensor zur Überwachung der Oberflächentemperatur kann an der Außenfläche des Gehäuses zur direkten Messung der Oberflächentemperatur angeordnet sein. Alternativ ist es auch möglich, die Temperatur der Atmosphäre im Inneren des Gehäuses zu messen, die charakteristisch ist für die Oberflächentemperatur an der Außenfläche des Gehäuses. Eine weitere Möglichkeit besteht darin, die Temperatur an der ersten Wärmetauschereinheit zu ermitteln, die ebenfalls charakteristisch ist für die Oberflächentemperatur. Ferner können auch mehrere Temperatursensoren an einer oder mehreren der genannten Stellen angeordnet sein. Dadurch lassen sich redundante Temperaturinformationen ermitteln, was die Sicherheit weiter erhöht.

Bei einem bevorzugten Ausführungsbeispiel weist jede Durchführungseinheit einen Durchführungskörper auf, in dem der Durchgangskanal verläuft. Vorzugsweise hat der Durchführungskörper ein zünddurchschlagsicheres Außengewinde.

Axial benachbart zu diesem Außengewinde kann ein Dichtflansch vorhanden sein, um eine Abdichtung zwischen dem Durchführungskörper und der Gehäusewand, insbesondere der Außenfläche zu erreichen. Dadurch kann der Schutzgrad gemäß EN 60529 erhöht werden. Über das zünddurchschlagsichere Außengewinde des Durchführungskörpers kann eine zünddurchschlagsichere Befestigung an der Wand des Gehäuses erfolgen.

Vorteilhafte Ausgestaltungen der Erfindung ergeben sich aus den abhängigen Patentansprüchen sowie der Beschreibung. Die Beschreibung beschränkt sich auf wesentliche Merkmale der Erfindung. Nachfolgend werden bevorzugte Ausführungsbeispiele der Erfindung anhand der beigefügten Zeichnung im Einzelnen erläutert. Es zeigen:
Figur 1 in Blockschaltbild eines druckfest gekapselten Gehäuses mit Temperiervorrichtung,
Figur 2 einen Durchführungskörper mit Blick entlang der Längsachse des Durchgangskanals auf die Außenfläche der Wand des Gehäuses,
Figur 3 den Durchführungskörper aus Figur 2 in einem schematischen Längsschnitt der Schnittlinie III-III.

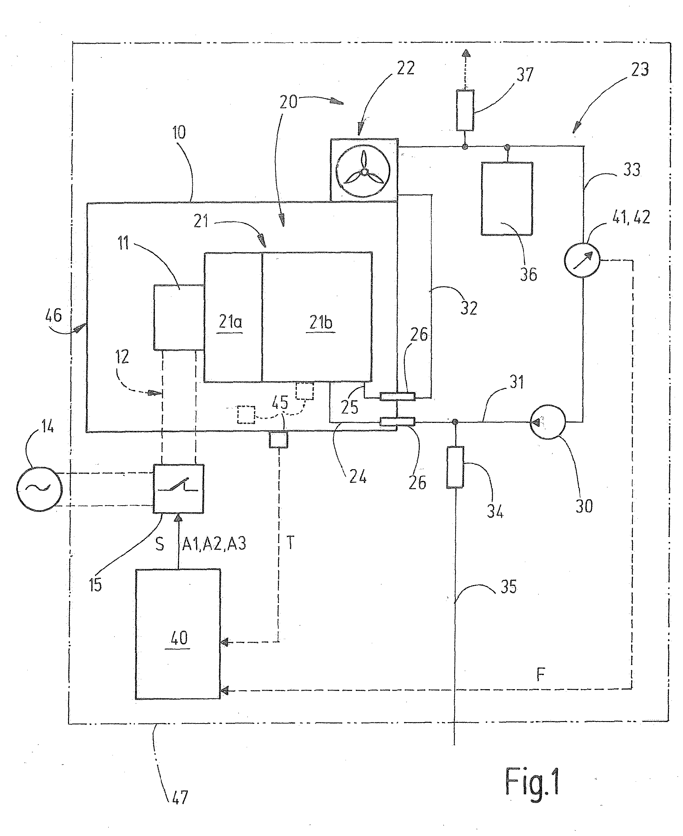

Das Blockschaltbild in Figur 1 zeigt ein explosionsgeschütztes Gehäuse 10 in der Zündschutzart druckfeste Kapselung (Ex-d). In dem Gehäuse 10 sind eine oder mehrere elektrische und/oder elektronische Komponenten 11 angeordnet. Über eine elektrische Versorgungsleitung 12 wird die wenigstens eine Komponente 11 mit elektrischer Energie versorgt. Die Versorgungsleitung 12 ist zünddurchschlagsicher durch eine Wand 13 des Gehäuses 10 hindurchgeführt. Die Versorgungsleitung 12 kann zwei oder mehr elektrische Leiter aufweisen. Es ist beispielsweise an eine Netzspannungsquelle 14 angeschlossen.

In der Versorgungsleitung 12 bzw. in zumindest einem Leiter der Versorgungsleiter 12 ist eine ansteuerbare Trenneinrichtung 15 angeordnet. Die Trenneinrichtung 15 unterbricht die Spannung und Stromversorgung der wenigstens einen Komponente 11 in ihren Trennzustand. In diesen Trennzustand kann die Trenneinrichtung 15 durch ein entsprechendes Steuersignal S umgeschaltet werden.

Die elektrischen Leitungen sind in Figur 1 zur Unterscheidung gegenüber den später beschriebenen Flüssigkeitsleitungen gestrichelt veranschaulicht.

Dem Gehäuse 10 ist eine Temperiervorrichtung 20 zur Temperierung der wenigstens einen Komponente 11 zugeordnet. Die Temperiervorrichtung 20 kann zur Kühlung und/oder Erwärmung der wenigstens einen Komponente 11 dienen.

Die Temperiervorrichtung 20 weist eine im Inneren des Gehäuses 10 angeordnete erste Wärmetauschereinheit 21 und eine außerhalb des Gehäuses 10 angeordnete zweite Wärmetauschereinheit 22 auf. Die beiden Wärmetauschereinheiten 21, 22 sind über einen Flüssigkeitskreislauf 23 miteinander verbunden. Zum Wärmetransport zwischen den beiden Wärmetauschereinheiten 21, 22 zirkuliert in den Leitungen des Flüssigkeitskreislaufs 23 eine Flüssigkeit, z.B. Wasser oder Öl, die als Wärmeträgermedium dient.

Der Aufbau der Wärmetauschereinheiten 21, 22 ist grundsätzlich beliebig. Hierbei bestehen eine Vielzahl von Möglichkeiten. Bei dem in Figur 1 dargestellten Ausführungsbeispiel weist die erste Wärmetauschereinheit 21 einen in Wärme übertragendem Kontakt mit der wenigstens einen Komponente 11 stehenden Wärmeübertragungsteil 21a sowie einen in Wärme übertragendem Kontakt mit dem Wärmeübertragsteil 21a stehenden mediumseitigen Teil 21b auf. Der mediumseitige Teil 21b ist an den Flüssigkeitskreislauf angeschlossen und von der dort zirkulierenden Flüssigkeit durchströmt.

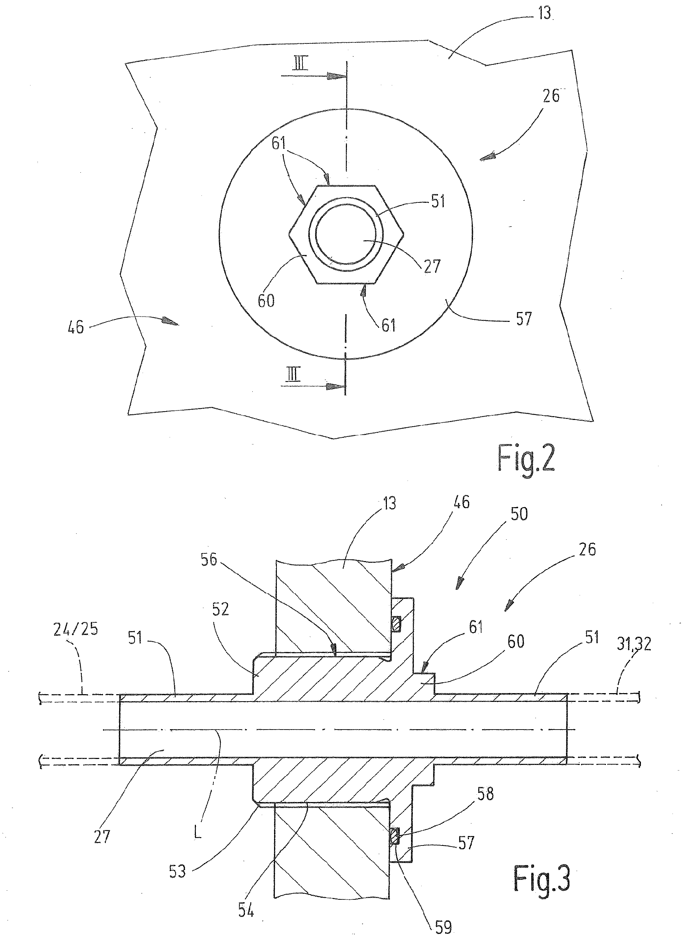

Im Inneren des Gehäuses weist der Flüssigkeitskreislauf 23 eine Zulaufleitung 24 sowie eine Rücklaufleitung 25 auf, die jeweils fluidisch mit der ersten Wärmetauschereinheit 21 und beispielsgemäß mit dem mediumseitigen Teil 21b verbunden sind. Sowohl die Zulaufleitung 24, als auch die Rücklaufleitung 25 sind im Inneren des Gehäuses 10 jeweils an eine Durchführungseinheit 26 angeschlossen. Jede Durchführungseinheit 26 weist einen Durchgangskanal 27 (Figur 3) auf, durch den Flüssigkeit in die Zulaufleitung 24 bzw. aus der Rücklaufleitung 25 hindurch strömen kann. Die Durchführungseinheiten 26 sind zünddurchschlagsicher in eine Wand 13 des Gehäuses 10 eingesetzt.

Bei dem in Figur 1 dargestellten Ausführungsbeispiel weist der Flüssigkeitskreislauf 23 eine Flüssigkeitspumpe 30 auf, die beispielsgemäß außerhalb des Gehäuses 10 angeordnet ist und deswegen explosionsgeschützt ausgeführt ist. Alternativ dazu könnte die Flüssigkeitspumpe 30 im Gehäuse 10 explosionsgeschützt angeordnet werden. Stromabwärts ist die Flüssigkeitspumpe 30 beispielsgemäß über eine erste Flüssigkeitsleitung 31 fluidisch über eine der beiden Durchführungseinheiten 26 mit der Zulaufleitung 24 verbunden.

Eine zweite Flüssigkeitsleitung 32 des Flüssigkeitskreislaufes 23 ist fluidisch über die jeweils andere Durchführungseinheit 26 fluidisch mit der Rücklaufleitung 25 verbunden und führt zur zweiten Wärmetauschereinheit 22. Eine dritte Flüssigkeitsleitung 33 des Flüssigkeitskreislauf 23 führt von der zweiten Wärmetauschereinheit 22 zurück zur Flüssigkeitspumpe 30. Somit entsteht ein geschlossener Flüssigkeitskreislauf 23.

Beim Ausführungsbeispiel ist an die erste Flüssigkeitsleitung 31 ein Überdruckventil 34 angeschlossen, so dass bei zu hohem Flüssigkeitsdruck stromabwärts der Flüssigkeitspumpe eine Flüssigkeitsmenge aus dem Flüssigkeitskreislauf 23 zur Druckreduzierung abgeführt werden kann. Dazu ist das Überdruckventil 34 an eine Überdruckleitung 35 angeschlossen.

Stromaufwärts der Flüssigkeitspumpe 30 kann ein Ausgleichsbehälter mit dem Flüssigkeitskreislauf 23 und beispielsgemäß der dritten Flüssigkeitsleitung 33 verbunden sein. Der Ausgleichsbehälter 36 ist vorzugsweise als Membranspeicher ausgeführt. Über den Ausgleichsbehälter 36 kann sichergestellt werden, dass der Flüssigkeitspumpe 30 stets eine ausreichende Menge an Flüssigkeit zur Verfügung gestellt wird. Um Gas und insbesondere Luft aus dem Flüssigkeitskreislauf 23 entfernen zu können, weist dieser beim Ausführungsbeispiel außerdem einen Entlüfter 37 auf. Dieser Entlüfter 37 ist insbesondere dann vorteilhaft, wenn ein gasender Membranspeicher als Ausgleichsbehälter 36 verwendet wird, um in die Flüssigkeit eindringendes Gas bzw. Luft wieder aus dem Flüssigkeitskreislauf 23 entfernen zu können.

Zu der in Figur 1 dargestellten Anordnung gehört außerdem eine Überwachungseinheit 40. Außerdem ist wenigstens ein Flüssigkeitsüberwachungssensor 41 vorhanden, der beispielsgemäß als Drucksensor 42 ausgeführt ist. Der wenigstens eine Flüssigkeitsüberwachungssensor 41 erzeugt ein Flüssigkeitsüberwachungssignal F, das der Überwachungseinheit 40 zur Auswertung übermittelt wird.

Beispielsgemäß ist lediglich ein Flüssigkeitsüberwachungssensor 41 in Form des Drucksensors 42 vorhanden. Der Drucksensor 42 misst den Druck an einer Stelle des Flüssigkeitskreislaufs 23. Beim Ausführungsbeispiel wird der Flüssigkeitsdruck an der Stelle des Flüssigkeitskreislaufs 23 gemessen, an der in der Regel der geringste Flüssigkeitsdruck herrscht. Beim Ausführungsbeispiel ist der Drucksensor 42 deswegen stromaufwärts der Flüssigkeitspumpe 30 an deren Ansaugseite angeordnet und beispielsgemäß in die dritte Flüssigkeitsleitung 33 eingesetzt. In Abwandlung hierzu könnte der Flüssigkeitsdruck auch an mehreren Stellen im Kühlmittelkreislauf 23 gemessen und jeweils ein Flüssigkeitsüberwachungssignal F überzeugt und an die Überwachungseinheit 40 übermittelt werden.

Der Flüssigkeitsdruck im Flüssigkeitskreislauf 23 dient als Maß dafür, ob die Durchgangskanäle 27 der beiden Durchführungseinheiten 26 ausreichend mit Flüssigkeit gefüllt sind, so dass sich dort innerhalb des Durchgangskanals 27 keine Zündspalte bilden können. Wenn die Flüssigkeit den Querschnitt des Durchgangskanals 27 vorzugsweise vollständig schließt, ist die Bildung eines Zündspaltes im Durchgangskanal 27 vermieden. Dies wird erfindungsgemäß über den wenigstens einen Flüssigkeitsüberwachungssensor 41 überwacht. Ist der Flüssigkeitsdruck innerhalb des Flüssigkeitskreislaufs 23 an jeder Stelle ausreichend groß, dann sind die Flüssigkeitsleitungen vollständig mit Flüssigkeit gefüllt und die Bildung eines Zündspaltes ist vermieden. Deswegen wird als Flüssigkeitsüberwachungssensor 41 beispielsgemäß ein Drucksensor 42 verwendet.

In Abwandlung zu diesem Ausführungsbeispiel könnte als Flüssigkeitsüberwachungssensor 41 auch ein Füllstandssensor verwendet werden, der den Füllstand von Flüssigkeit im Flüssigkeitskreislauf 23 direkt misst. Es könnten auch mehrere Füllstandssensoren eingesetzt werden. Beispielsweise könnte jeder Durchführungseinheit 26 ein Füllstandssensor zugeordnet sein.

Eine weitere Abwandlung des bevorzugten Ausführungsbeispiels besteht darin, als wenigstens einen Flüssigkeitsüberwachungssensor einen oder mehrere Temperatursensoren einzusetzen. Durch die Messung der Temperatur beispielsweise an einer Stelle im Inneren des Gehäuses 10, kann ermittelt werden, ob eine ausreichende Kühlung bzw. Temperierung erfolgt. Dies ist dann gewährleistet, wenn ein ausreichend großer Volumen- oder Massenstrom der Flüssigkeit durch den Flüssigkeitskreislauf 23 zirkuliert. Eine Temperaturauswertung kann somit indirekt die Füllung im Flüssigkeitskreislauf 23 und mithin auch in den Durchgangskanälen 27 angeben. Ferner ist es auch möglich, den Volumenstrom und/oder den Massenstrom im Flüssigkeitskreislauf 23 und vorzugsweise in wenigstens einem der Durchgangskanäle 27 zu messen und daraus das Flüssigkeitsüberwachungssignal F zu erzeugen.

Auch eine beliebige Kombination der beschriebenen Möglichkeiten an Flüssigkeitsüberwachungssensoren 41 kann verwendet werden.

Der Überwachungseinheit 40 wird beim Ausführungsbeispiel außerdem ein Temperatursignal T eines Temperatursensors 45 übermittelt. Der Temperatursensor 45 dient zur Bestimmung der Oberflächentemperatur an wenigstens einer Stelle an der Außenfläche 46 des Gehäuses 10. Unabhängig davon, ob sich an der Außenfläche 46 des Gehäuses 10 an verschiedenen Stellen unterschiedliche Oberflächentemperaturen einstellen ist ausreichend, den aktuell herrschenden maximalen Oberflächentemperaturwert an der Außenfläche 46 des Gehäuses 10 zu ermitteln. Die Oberflächentemperatur darf einen vorgegebenen Wert nicht überschreiten. Denn ansonsten könnte das Gehäuse 10 selbst als Zündquelle in einer explosionsgefährdeten Umgebung dienen. Der Temperatursensor 45 erzeugt deswegen ein Temperatursignal T, das die Oberflächentemperatur bzw. den aktuell herrschenden maximalen Oberflächentemperaturwert an der Außenfläche 46 beschreibt.

Wie in Figur 1 dargestellt, kann der Temperatursensor 45 unmittelbar an der Außenfläche 46 des Gehäuses 10 angeordnet sein und deren Oberflächentemperatur messen. Abhängig von der Anordnung der wärmeabgebenden Komponenten 11 im Inneren des Gehäuses 10 können auch mehrere Temperatursensoren 45 auf der Außenfläche 46 des Gehäuses 10 an verschiedenen Stellen angeordnet werden, um den aktuell herrschenden maximalen Oberflächentemperaturwert bestimmen zu können, insbesondere wenn die Oberflächentemperaturen des Gehäuses 10 an verschiedenen Stellen voneinander abweichen können. Zusätzlich oder alternativ dazu kann die Temperatur auch an wenigstens einer anderen Stelle erfasst werden, die charakteristisch oder bestimmend für die Oberflächentemperatur an der Außenfläche 46 ist, beispielsweise die Temperatur in der Atmosphäre im Inneren des Gehäuses 10 und/oder die Temperatur an der ersten Wärmetauschereinheit 21 und/oder die Temperatur an der wenigstens einen Komponente 11. Beispielhafte alternative oder zusätzliche Möglichkeiten zur Anordnung eines Temperatursensors 45 sind in Figur 1 mit gepunktet gezeichneten Linien veranschaulicht.

Die Anordnung gemäß Figur 1 arbeitet wie folgt:
Über die Temperiervorrichtung 20 werden wenigstens eine elektrische und/oder elektronische Komponente 11 innerhalb des druckfest gekapselten Gehäuses 10 temperiert, beispielsweise gekühlt. Die Wärme wird über die erste Wärmetauschereinheit 21 auf die als Wärmeträgermedium dienende Flüssigkeit übertragen und mittels der Flüssigkeit zur zweiten Wärmetauschereinheit 22 außerhalb des Gehäuses transportiert. Dort wird die Wärme an die Umgebung abgegeben. Die zweite Wärmetauschereinheit 22 kann beispielsweise ein Gebläse aufweisen. Die Zirkulation der Flüssigkeit wird über die Flüssigkeitspumpe 30 aufrecht erhalten.

Über das Temperatursignal T des Temperatursensors 45 sowie das Flüssigkeitsüberwachungssignal F des Flüssigkeitsüberwachungssensors 41 wird der explosionsgeschützte Zustand des Gehäuses 10 überwacht. Steigt das Temperatursignal T über einen vorgegebenen Schwellenwert, ist die Explosionssicherheit nicht mehr gegeben. Die Überwachungseinheit 40 erzeugt dann ein den unzureichenden Explosionsschutz charakterisierendes drittes Ausgangssignal A3.

Ein den unzureichenden Explosionsschutz anzeigendes erstes Ausgangssignal A1 wird dann erzeugt, wenn die Füllung der Durchgangskanäle 27 der beiden Durchführungseinheiten 26 mit Flüssigkeit unzureichend ist. Hierfür wird das Flüssigkeitsüberwachungssignal F durch die Überwachungseinheit 40 ausgewertet, beispielsgemäß also der vom Drucksensor 42 gemessene Druck im Flüssigkeitskreislauf 23. Ist der Druck unzureichend, können sich in den Durchgangskanälen 27 Zündspalte bilden, so dass der Zustand der druckfesten Kapselung (Ex-d) nicht mehr gewährleistet ist.

Andernfalls, wenn die Füllung der Durchgangskanäle ausreichend und die Oberflächentemperatur der Außenfläche 46 des Gehäuses 10 im zulässigen Bereich liegt, erzeugt die Überwachungseinheit 40 ein zweites Ausgangssignal A2, das angibt, dass die überwachten Parameter den Anforderungen des Explosionsschutzes entsprechen.

Die Ausgangssignale A1, A2, A3 können als Steuersignal für die Trenneinrichtung 15 verwendet werden. Wird das zweite Ausgangssignal A2 erzeugt, bleibt die Trenneinrichtung 15 in ihrem leitenden Zustand und ermöglicht die Versorgung der wenigstens einen Komponente 11 mit elektrischer Energie. Sobald das erste Ausgangssignal A1 und/oder das dritte Ausgangssignal A3 erzeugt werden, dient dieses als Steuersignal S zum Umschalten der Trenneinrichtung 15 in den Trennzustand. Die Spannungs- und Stromversorgung der wenigstens einen Komponente 11 mit elektrischer Energie über die Versorgungsleitung 12 wird unterbunden.

Alternativ oder zusätzlich könnte über das erste Ausgangssignal A1 und/oder das dritte Ausgangssignal A3auch ein optisches und/oder akustisches und/oder haptisches Alarmsignal für eine Bedienperson erzeugt werden, das den unzureichenden Explosionsschutz und optional auch den Grund (zu hohe Oberflächentemperatur beim dritten Ausgangssignal A3 und/oder zu geringer Flüssigkeitsfüllstand im Durchgangskanal beim ersten Ausgangssignal A1) anzeigt. Es versteht sich, dass es auch möglich ist, den ordnungsgemäßen Zustand optisch und/akustisch und/haptisch anzuzeigen oder auszugeben, wenn das zweite Ausgangssignal A2 durch die Überwachungseinheit 40 erzeugt wird.

Wie in Figur 1 schematisch durch die strichpunktierte Linie veranschaulich ist, kann das druckfest gekapselte Gehäuse 10 sowie die Temperiervorrichtung 20 in und/oder an einem Außengehäuse 47 angeordnet sein.

Ein Ausführungsbeispiel für eine Durchführungseinheit 26 ist in Figur 3 veranschaulicht. Die Durchführungseinheit 26 weist einen Durchführungskörper 50 auf, der von dem Durchgangskanal 27 durchsetzt ist. Der Durchgangskanal 27 ist beispielsgemäß zylindrisch und erstreckt sich entlang einer Längsachse L. Die beiden Mündungen des Durchgangskanals 27 sind jeweils an einem rohrförmigen Endabschnitt 51 des Durchführungskörpers vorhanden. Die beiden rohrförmigen Endabschnitte sind über einen zentralen Abschnitt 52 mit größerem Außendurchmesser miteinander verbunden. An dem zentralen Abschnitt 52 ist ein zünddurchschlagsicheres Außengewinde 53 vorhanden. Dem Außengewinde 53 ist beim Ausführungsbeispiel ein zünddurchschlagsicheres Innengewinde 54 zugeordnet. Das Innengewinde 54 ist beim Ausführungsbeispiel unmittelbar in der Wand 13 des Gehäuses 10 oder in einer dort zünddurchschlagsicher angeordneten Gewindebuchse vorhanden. Der Durchführungskörper 50 wird mit seinem Außengewinde 53 somit unmittelbar in das durch das Innengewinde 54 begrenzte Durchgangsloch in der Wand 13 eingeschraubt. Das Außengewinde 53 und das Innengewinde 54 stellen gemeinsam ein zünddurchschlagsicheres Befestigungsmittel 55 zur Befestigung der Durchführungseinheit 26 an der Wand 13 des Gehäuses 10 dar, wie es in Figur 3 gezeigt ist. Zwischen dem Innengewinde 54 und dem Außengewinde 53 ist durch den Gewindeeingriff ein zünddurchschlagsicherer Gewindespalt 56 gebildet.

In Richtung der Längsachse L benachbart zum Außengewinde 53 weist der Durchführungskörper 50 einen Dichtflansch 57 auf, dessen Außendurchmesser größer ist als der des Außengewindes 53. Zwischen dem Dichtflansch 57 und der Wand 13 des Gehäuses 10 kann wenigstens eine Dichtung 58 angeordnet sein, insbesondere um den Schutzgrad zu erhöhen. Die Dichtung 58 ist bei dem hier beschriebenen Ausführungsbeispiel in eine ringförmige, insbesondere kreisringförmige Nut 59 eingelegt. Die Nut 59 ist auf der dem Außengewinde 53 zugewandten Seite des Dichtflansches 57 offen und kann so in Kontakt mit der Wand 13 bzw. mit der Außenfläche 46 gelangen.

Auf der dem Außengewinde 53 abgewandten Seite des Dichtflansches 57 kann am Dichtungskörper 50 ein Angriffsteil 60 zum Angreifen des Dichtungskörpers 50 mit einem Werkzeug vorhanden sein. Das Angriffsteil 60 ist beispielweise als Außensechskant mit sechs Angriffsflächen 61 für einen Gabelschlüssel oder ein ähnliches Werkzeug ausgeführt. Dadurch kann der Durchführungskörper 50 beim Festschrauben mit einem Werkzeug gedreht und fest an der Wand 13 des Gehäuses 10 angebracht bzw. wieder gelöst werden.

Die Leitungen des Flüssigkeitskreislaufs 23 werden jeweils mit einem rohrförmigen Endabschnitt 51 im Inneren des Gehäuses 10 bzw. außerhalb des Gehäuses 10 verbunden, was in Figur 3 lediglich gestrichelt schematisch veranschaulicht ist.

Bei allen Ausführungsbeispielen ist die als Wärmeträgermedium verwendete Flüssigkeit derart ausgewählt, dass weder die Flüssigkeit selbst, noch ihre Zersetzungsprodukte brennbar sind oder explosive Stoffe darstellen oder enthalten oder freisetzen.

Die Erfindung betrifft ein druckfest gekapseltes Gehäuse 10 mit einer Temperiervorrichtung 20 sowie ein Verfahren zur Überwachung des druckfest gekapselten Gehäuses 10. Die Temperiervorrichtung enthält eine erste Wärmetauschereinheit 21 im Inneren des Gehäuses 10 und eine zweite Wärmetauschereinheit 22 außerhalb des Gehäuses 10. Über Flüssigkeitsleitungen eines Flüssigkeitskreislaufs 23 sind die Wärmetauschereinheiten 21, 22 miteinander fluidisch verbunden. In der Wand 13 des Gehäuses 10 sitzen zwei Durchführungseinheiten 26, die jeweils einen Durchgangskanal 27 aufweisen. Die Durchgangskanäle 27 sind Bestandteil des Flüssigkeitskreislaufs 23 und sowohl im Inneren, als auch außerhalb des Gehäuses fluidisch mit den jeweils zugeordneten Leitungen verbunden. Ein Flüssigkeitsüberwachungssensor 41 erzeugt ein Flüssigkeitsüberwachungssignal F, das angibt, wenn die Füllung eines Durchgangskanals 27 in einer Durchgangseinheit 26 unzureichend ist. Denn in diesem Fall kann über den Durchgangskanal 27 ein Zündspalt in der Durchgangseinheit 26 geschaffen werden. Das Flüssigkeitsüberwachungssignal F wird einer Überwachungseinheit 40 übermittelt, die das Signal auswertet. Ergibt diese Auswertung, dass der Grad der Füllung bzw. der Füllstand innerhalb des Durchgangskanals 27 zu gering ist und die Anforderungen an den Explosionsschutz nicht mehr erfüllt werden, erzeugt die Überwachungseinheit 40 ein erstes Ausgangssignal A1. Über dieses Ausgangssignal A1 kann ein Alarm ausgeführt werden und/oder die Komponenten 11 innerhalb des Gehäuses 10 spannungs- und stromfrei geschaltet werden.

### Bezugszeichenliste:

- 10: Gehäuse
- 11: Komponente
- 12: Versorgungsleitung
- 13: Wand
- 14: Netzspannungsquelle
- 15: Trenneinrichtung

- 20: Temperiervorrichtung
- 21: erste Wärmetauschereinheit
- 21a: Wärmeübertragungsteil
- 21b: mediumseitiger Teil
- 22: zweite Wärmetauschereinheit
- 23: Flüssigkeitskreislauf
- 24: Zulaufleitung
- 25: Rücklaufleitung
- 26: Durchführungseinheit
- 27: Durchgangskanal

- 30: Flüssigkeitspumpe
- 31: erste Flüssigkeitsleitung
- 32: zweite Flüssigkeitsleitung
- 33: dritte Flüssigkeitsleitung
- 34: Überdruckventil
- 35: Überdruckleitung
- 36: Ausgleichsbehälter
- 37: Entlüfter

- 40: Überwachungseinheit
- 41: Flüssigkeitsüberwachungssensor
- 42: Drucksensor
- 45: Temperatursensors
- 46: Außenfläche des Gehäuses
- 47: Außengehäuse

- 50: Durchführungskörper
- 51: rohrförmiger Endabschnitt
- 52: zentraler Abschnitt
- 53: Außengewinde
- 54: Innengewinde
- 55: Befestigungsmittel
- 56: zünddurchschlagsicherer Spalt
- 57: Dichtflansch
- 58: Dichtung
- 59: Nut
- 60: Angriffsteil
- 61: Angriffsfläche

- A1: erstes Ausgangssignal
- A2: zweites Ausgangssignal
- A3: drittes Ausgangssignal
- F: Flüssigkeitsüberwachungssignal
- L: Längsachse
- S: Steuersignal
- T: Temperatursignal

## Patentansprüche

1. Druckfest gekapseltes Gehäuse (10),
mit einer Temperiervorrichtung (20), die eine im Inneren des Gehäuses (10) angeordnete erste Wärmetauschereinheit (21) und eine außerhalb des Gehäuses (10) angeordnete zweite Wärmetauschereinheit (22) aufweist,
wobei die beiden Wärmetauschereinheiten (21, 22) über einen Flüssigkeitskreislauf (23) miteinander verbunden sind,
wobei der Flüssigkeitskreislauf (23) im Gehäuse (10) eine Zulaufleitung (24) und eine Rücklaufleitung (25) aufweist, die mit der ersten Wärmetauschereinheit (21) verbunden sind und die fluidisch jeweils an einen Durchgangskanal (27) einer Durchführungseinheit (26) angeschlossen sind,
wobei die Durchführungseinheiten (26) über jeweils ein Befestigungsmittel (55) zünddurchschlagsicher in einer Wand (13) des Gehäuses (10) angeordnet sind, so dass sich der Durchgangskanal (27) durch die Wand (13) erstreckt,
**dadurch gekennzeichnet, dass** wenigstens ein Flüssigkeitsüberwachungssensor (41) vorhanden ist, der ein für die Füllung der Durchgangskanäle (27) mit Flüssigkeit charakteristisches Flüssigkeitsüberwachungssignal (F) erzeugt und an eine Überwachungseinheit (40) übermittelt,
wobei die Überwachungseinheit (40) dazu eingerichtet ist, das Flüssigkeitsüberwachungssignal (F) auszuwerten und ein den unzureichenden Explosionsschutz charakterisierendes erstes Ausgangssignal (A1) erzeugt, wenn das Flüssigkeitsüberwachungssignal (F) des wenigstens einen Flüssigkeitsüberwachungssensors (41) anzeigt, dass zumindest einer der beiden Durchgangskanäle (27) eine derart unzureichende Füllung mit Flüssigkeit aufweist, dass sich in diesem Durchgangskanal (27) ein Zündspalt bilden kann,
und wobei weder die Flüssigkeit selbst, noch ihre Zersetzungsprodukte brennbar sind oder explosive Stoffe darstellen oder enthalten oder freisetzen.

2. Druckfest gekapseltes Gehäuse nach Anspruch 1,
**dadurch gekennzeichnet, dass** die Überwachungseinheit (40) mit einer ansteuerbaren Trenneinrichtung (15) verbunden ist, die mit einer in das Gehäuse (10) führenden elektrischen Versorgungsleitung (12) verbunden ist und in einem Trennzustand die Zufuhr von elektrischer Energie in das Gehäuse (10) unterbricht.

3. Druckfest gekapseltes Gehäuse nach Anspruch 2,
**dadurch gekennzeichnet, dass** die Überwachungseinheit (40) mittels dem den unzureichenden Explosionsschutz charakterisierenden ersten Ausgangssignal (A1) die Trenneinrichtung (15) in den Trennzustand umschaltet.

4. Druckfest gekapseltes Gehäuse nach einem der vorhergehenden Ansprüche,
**dadurch gekennzeichnet, dass** wenigstens einer der Flüssigkeitsüberwachungssensoren (41) von einem Füllstandssensor zur Messung des Füllstands in einem zugeordneten Durchgangskanal (27) oder von einem Drucksensor (42) zur Messung des Flüssigkeitsdrucks im Flüssigkeitskreislauf (23) oder von einem Temperatursensor gebildet ist.

5. Druckfest gekapseltes Gehäuse nach einem der vorhergehenden Ansprüche,
**dadurch gekennzeichnet, dass** die Überwachungseinheit (40) mit wenigstens einem Temperatursensor (45) verbunden ist, der ein für wenigstens einen Oberflächentemperaturwert an der Außenfläche (46) des Gehäuses (10) charakteristisches Temperatursignal (T) erzeugt.

6. Druckfest gekapseltes Gehäuse nach Anspruch 5,
**dadurch gekennzeichnet, dass** die Überwachungseinheit (40) ein den unzureichenden Explosionsschutz charakterisierendes drittes Ausgangssignal (A3) erzeugt, wenn das Temperatursignal (T) des wenigstens einen Temperatursensors (45) einen vorgegebenen Schwellenwert überschreitet.

7. Druckfest gekapseltes Gehäuse nach Anspruch 6 und 2,
**dadurch gekennzeichnet, dass** die Überwachungseinheit (40) mittels dem den unzureichenden Explosionsschutz charakterisierenden dritten Ausgangssignal (A3) die Trenneinrichtung (15) in den Trennzustand umschaltet.

8. Druckfest gekapseltes Gehäuse nach einem der Ansprüche 5 bis 7,
**dadurch gekennzeichnet, dass** der Temperatursensor (45) an der Außenfläche (46) des Gehäuses (10) oder im Inneren des Gehäuses (10) oder an der ersten Wärmetauschereinheit (21) oder an einer im Inneren des Gehäuses 10 angeordneten Komponente (11) angeordnet ist.

9. Druckfest gekapseltes Gehäuse nach einem der vorhergehenden Ansprüche,
**dadurch gekennzeichnet, dass** die Durchführungseinheit (26) einen den Durchgangskanal (27) aufweisenden Durchführungskörper (50) aufweist, an dem ein Außengewinde (53) vorhanden ist.

10. Druckfest gekapseltes Gehäuse nach Anspruch 9,
**dadurch gekennzeichnet, dass** der Durchführungskörper (50) axial benachbart zu dem Außengewinde (53) einen Dichtflansch (57) aufweist.

11. Verfahren zur Überwachung eines druckfest gekapselten Gehäuses (10) mit einer Temperiervorrichtung (20), die eine im Inneren des Gehäuses (10) angeordnete erste Wärmetauschereinheit (21) und eine außerhalb des Gehäuses (10) angeordnete zweite Wärmetauschereinheit (22) aufweist, wobei die beiden Wärmetauschereinheiten (21, 22) über einen Flüssigkeitskreislauf (23) miteinander verbunden sind, wobei der Flüssigkeitskreislauf (23) eine Zulaufleitung (24) und eine Rücklaufleitung (25) aufweist, die im Inneren des Gehäuses (10) mit der ersten Wärmetauschereinheit (21) verbunden sind und die fluidisch jeweils an einen Durchgangskanal (27) einer Durchführungseinheit (26) angeschlossen sind, wobei die Durchführungseinheiten (26) über jeweils ein Befestigungsmittel (55) zünddurchschlagsichere in einer Wand (13) des Gehäuses (10) angeordnet sind, so dass sich der Durchgangskanal (27) durch die Wand (13) erstreckt, **dadurch gekennzeichnet, dass** die Füllung der Durchgangskanäle (27) mit Flüssigkeit sensorisch überwacht wird und ein charakteristisches Flüssigkeitsüberwachungssignal (F) erzeugt und an eine Überwachungseinheit (40) übermittelt wird,
wobei das Flüssigkeitsüberwachungssignal (F) ausgewertet und ein den unzureichenden Explosionsschutz charakterisierendes erstes Ausgangssignal (A1) erzeugt wird, wenn das Flüssigkeitsüberwachungssignal (F) anzeigt, dass zumindest einer der beiden Durchgangskanäle (27) eine derart unzureichende Füllung mit Flüssigkeit aufweist, dass sich in diesem Durchgangskanal (27) ein Zündspalt bilden kann,
und wobei weder die Flüssigkeit selbst, noch ihre Zersetzungsprodukte brennbar sind oder explosive Stoffe darstellen oder enthalten oder freisetzen.

## Claims

1. Pressure-tightly encapsulated housing (10),
with a tempering device (20) which has a first heat exchanger unit (21) arranged in the interior of the housing (10) and a second heat exchanger unit (22) arranged outside the housing (10),
wherein the two heat exchanger units (21, 22) are connected together via a fluid circuit (23),
wherein the fluid circuit (23) in the housing (10) has a supply line (24) and a return line (25) which are connected to the first heat exchanger unit (21) and are each fluidically connected to a passage channel (27) of a lead-through unit (26),
wherein the lead-through units (26) are each arranged in a wall (13) of the housing (10) via a fixing means (55) so as to be protected against ignition breakthrough, so that the passage channel (27) extends through the wall (13),
**characterised in that** at least one fluid-monitoring sensor (41) is present which generates a fluid-monitoring signal (F) characteristic of the level of fluid in the passage channels (27) and transmits said signal to a monitoring unit (40),
wherein the monitoring unit (40) is configured to evaluate the fluid-monitoring signal (F) and generate a first output signal (A1) characteristic of the inadequate explosion protection if the fluid-monitoring signal (F) from the at least one fluid-monitoring sensor (41) indicates that at least one of the two passage channels (27) is inadequately filled with fluid, such that an ignition gap can form in this passage channel (27),
and wherein neither the fluid itself nor its decomposition products are combustible or constitute or contain or release explosive substances.

2. Pressure-tightly encapsulated housing according to claim 1, **characterised in that** the monitoring unit (40) is connected to a controllable isolating device (15) which is connected to an electrical supply line (12) leading into the housing (10) and, in an isolating state, interrupts the supply of electrical energy into the housing (10).

3. Pressure-tightly encapsulated housing according to claim 2, **characterised in that** the monitoring unit (40), by means of the first output signal (A1) characteristic of the inadequate explosion protection, switches the isolating device (15) into the isolating state.

4. Pressure-tightly encapsulated housing according to any of the preceding claims, **characterised in that** at least one of the fluid-monitoring sensors (41) is formed by a fill level sensor for measuring the fill level in an assigned passage channel (27) or by a pressure sensor (42) for measuring the fluid pressure in the fluid circuit (23) or by a temperature sensor.

5. Pressure-tightly encapsulated housing according to any of the preceding claims, **characterised in that** the monitoring unit (40) is connected to at least one temperature sensor (45) which generates a temperature signal (T) characteristic of at least one surface temperature value on the outer face (46) of the housing (10).

6. Pressure-tightly encapsulated housing according to claim 5, **characterised in that** the monitoring unit (40) generates a third output signal (A3) characteristic of the inadequate explosion protection if the temperature signal (T) of the at least one temperature sensor (45) exceeds a predefined threshold value.

7. Pressure-tightly encapsulated housing according to claim 6 and 2, **characterised in that** the monitoring unit (40), by means of the third output signal (A3) characteristic of the inadequate explosion protection, switches the isolating device (15) into the isolating state.

8. Pressure-tightly encapsulated housing according to any of claims 5 to 7, **characterised in that** the temperature sensor (45) is arranged on the outer face (46) of the housing (10) or in the interior of the housing (10) or on the first heat exchanger unit (21) or on a component (11) arranged in the interior of the housing (10).

9. Pressure-tightly encapsulated housing according to any of the preceding claims, **characterised in that** the lead-through unit (26) has a lead-through body (50) comprising the passage channel (27), on which body an external thread (53) is provided.

10. Pressure-tightly encapsulated housing according to claim 9, **characterised in that** the lead-through body (50) has a sealing flange (57) axially adjacent to the external thread (53).

11. Method for monitoring a pressure-tightly encapsulated housing (10) with a tempering device (20) which has a first heat exchanger unit (21) arranged in the interior of the housing (10) and a second heat exchanger unit (22) arranged outside the housing (10), wherein the two heat exchanger units (21, 22) are connected together via a fluid circuit (23), wherein the fluid circuit (23) has a supply line (24) and a return line (25) which are connected in the housing (10) to the first heat exchanger unit (21) and are fluidically connected each to a passage channel (27) of a lead-through unit (26), wherein the lead-through units (26) are arranged in a wall (13) of the housing (10) via a fixing means (55) so as to be protected against ignition breakthrough, so that the passage channel (27) extends through the wall (13),
**characterised in that** the level of fluid in the passage channels (27) is monitored by sensors and a characteristic fluid-monitoring signal (F) is produced and transmitted to a monitoring unit (40),
wherein the fluid-monitoring signal (F) is evaluated and a first output signal (A1) characteristic of the inadequate explosion protection is produced if the fluid-monitoring signal (F) indicates that at least one of the two passage channels (27) has an inadequate level of fluid, such that an ignition gap can form in this passage channel (27),
and wherein neither the fluid itself nor its decomposition products are combustible or constitute or contain or release explosive substances.

## Revendications

1. Boîtier (10) à enveloppe antidéflagrante,
comprenant un dispositif de régulation de température (20) qui présente une première unité d'échangeur de chaleur (21), disposée à l'intérieur du boîtier (10), et une deuxième unité d'échangeur de chaleur (22) disposée à l'extérieur du boîtier (10),
les deux unités d'échangeur de chaleur (21, 22) étant reliées l'une à l'autre par un circuit de liquide (23),
le circuit de liquide (23) présentant, dans le boîtier (10), une conduite d'arrivée (24) et une conduite de retour (25) qui sont reliées à la première unité d'échangeur de chaleur (21) et qui sont raccordées sur le plan fluidique respectivement à un conduit de passage (27) d'une unité de traversée (26),
les unités de traversée (26) étant disposées de manière antidéflagrante dans une paroi (13) du boîtier (10), respectivement par l'intermédiaire d'un moyen de fixation (55), de sorte que le conduit de passage (27) s'étend à travers la paroi (13),
**caractérisé en ce qu'**il est prévu au moins un capteur de surveillance de liquide (41) qui produit un signal de surveillance de liquide (F), caractéristique du remplissage des conduits de passage (27) avec du liquide, et le transmet à une unité de surveillance (40),
l'unité de surveillance (40) étant conçue pour évaluer le signal de surveillance de liquide (F) et produisant un premier signal de sortie (Al), caractérisant la protection insuffisante contre l'explosion, lorsque le signal de surveillance de liquide (F) du capteur de surveillance de liquide (41), au nombre d'au moins un, indique qu'au moins un des deux conduits de passage (27) présente un remplissage avec du liquide qui est insuffisant au point qu'un interstice explosible peut se former dans ce conduit de passage (27),
et ni le liquide lui-même, ni ses produits de décomposition n'étant combustibles ou ne constituant ou ne contenant ou ne libérant des substances explosives.

2. Boîtier à enveloppe antidéflagrante selon la revendication 1, **caractérisé en ce que** l'unité de surveillance (40) est reliée à un dispositif de sectionnement (15) pouvant être activé, qui est relié à une ligne d'alimentation (12) électrique menant dans le boîtier (10) et. à l'état de sectionnement, interrompt l'alimentation d'énergie électrique dans le boîtier (10).

3. Boîtier à enveloppe antidéflagrante selon la revendication 2, **caractérisé en ce que** l'unité de surveillance (40), par le biais du premier signal de sortie (A1) caractérisant la protection insuffisante contre l'explosion, commute le dispositif de sectionnement (15) pour le faire passer à l'état de sectionnement.

4. Boîtier à enveloppe antidéflagrante selon une des revendications précédentes, **caractérisé en ce qu'**au moins un des capteurs de surveillance de liquide (41) est constitué d'un capteur de niveau destiné à mesurer le niveau de remplissage dans un conduit de passage (27) associé, ou d'un capteur de pression (42) destiné à mesurer la pression du liquide dans le circuit de liquide (23), ou d'un capteur de température.

5. Boîtier à enveloppe antidéflagrante selon une des revendications précédentes, **caractérisé en ce que** l'unité de surveillance (40) est reliée à au moins un capteur de température (45) qui produit un signal de température (T) caractéristique d'au moins une valeur de température de surface sur la surface extérieure (46) du boîtier (10).

6. Boîtier à enveloppe antidéflagrante selon la revendication 5, **caractérisé en ce que** l'unité de surveillance (40) produit un troisième signal de sortie (A3) caractérisant la protection insuffisante contre l'explosion, lorsque le signal de température (T) du capteur de température (45), au nombre d'au moins un, dépasse une valeur seuil prédéterminée.

7. Boîtier à enveloppe antidéflagrante selon les revendications 6 et 2, **caractérisé en ce que** l'unité de surveillance (40), par le biais du troisième signal de sortie (A3) caractérisant la protection insuffisante contre l'explosion, commute le dispositif de sectionnement (15) pour le faire passer à l'état de sectionnement.

8. Boîtier à enveloppe antidéflagrante selon une des revendications 5 à 7, **caractérisé en ce que** le capteur de température (45) est disposé sur la surface extérieure (46) du boîtier (10) ou à l'intérieur du boîtier (10) ou sur la première unité d'échangeur de chaleur (21) ou sur un composant (11) situé à l'intérieur du boîtier (10).

9. Boîtier à enveloppe antidéflagrante selon une des revendications précédentes, **caractérisé en ce que** l'unité de traversée (26) présente un corps de traversée (50) qui comporte le conduit de passage (27) et sur lequel il est prévu un filetage extérieur (53).

10. Boîtier à enveloppe antidéflagrante selon la revendication 9, **caractérisé en ce que** le corps de traversée (50) présente une bride d'étanchéité (57) dans le voisinage axial du filetage extérieur (53).

11. Procédé de surveillance d'un boîtier (10) à enveloppe antidéflagrante comprenant un dispositif de régulation de température (20) qui présente une première unité d'échangeur de chaleur (21), disposée à l'intérieur du boîtier (10), et une deuxième unité d'échangeur de chaleur (22) disposée à l'extérieur du boîtier (10), les deux unités d'échangeur de chaleur (21, 22) étant reliées l'une à l'autre par un circuit de liquide (23), le circuit de liquide (23) présentant une conduite d'arrivée (24) et une conduite de retour (25) qui sont reliées à la première unité d'échangeur de chaleur (21), à l'intérieur du boîtier (10), et qui sont raccordées sur le plan fluidique respectivement à un conduit de passage (27) d'une unité de traversée (26), les unités de traversée (26) étant disposées de manière antidéflagrante dans une paroi (13) du boîtier (10), respectivement par l'intermédiaire d'un moyen de fixation (55), de sorte que le conduit de passage (27) s'étend à travers la paroi (13),
**caractérisé en ce que** le remplissage des conduits de passage (27) avec du liquide est surveillé à l'aide de capteurs et un signal de surveillance de liquide (F) caractéristique est produit et est transmis à une unité de surveillance (40),
le signal de surveillance de liquide (F) étant évalué et un premier signal de sortie (Al), caractéristique de la protection insuffisante contre l'explosion, étant produit lorsque le signal de surveillance de liquide (F) indique qu'au moins un des deux canaux de passage (27) présente un remplissage avec du liquide qui est insuffisant au point qu'un interstice explosible peut se former dans ce conduit de passage (27),
et ni le liquide lui-même, ni ses produits de décomposition n'étant combustibles ou ne constituant ou ne contenant ou ne libérant des substances explosives.
